# EUROPEAN PATENT SPECIFICATION

(11) **EP 1 135 826 B1**
(45) Date of publication and mention of the grant of the patent: **12.03.2008**
(21) Application number: 99963753.1
(22) Date of filing: 24.11.1999
(51) Int. Cl.: H01P 1/213, H01P 1/203

(54) **MICROSTRIP FILTER DEVICE**
MIKROSTREIFEN-FILTERANORDNUNG
DISPOSITIF FILTRANT A MICRORUBANS

(30) Priority: 01.12.1998 SE 9804153
(43) Date of publication of application: 26.09.2001
(73) Proprietor: ALLGON AB, 187 80 Täby (SE)
(72) Inventor: LINDQVIST, Leif, S-184 41 kersberga (SE)
(74) Representative: Modin, Jan
(86) International application number: PCT/SE1999/002181
(87) International publication number: WO 2000/033413

(56) References cited:
- US-A- 5 192 927
- US-A- 5 317 291

## Description

### TECHNICAL FIELD OF INVENTION

The present invention relates in general to a high-power filter means and more particularly to a microstrip filter means.

### DESCRIPTION OF RELATED ART

The continued growth of subscribers in different cellular systems has led to the situation where the call intensity, in peak traffic hours, reaches a maximum number of simultaneous calls due to limited frequency band availability. Thus, an operator might be restricted in adding new subscribers to the cellular system. This is solved by introducing new frequency bands used for communication. For instance, the mobile telephony system band 900 MHz is supplemented in some areas by PCN/GSM 1800 Mhz. A subscriber having a dual band cellular phone may thus use any of the two frequency bands for communication resulting in less congestion, and the operator may add more subscribers to the combined system and will thus obtain even more revenues.

The use of two different frequency bands by one operator may require the operator to use two different antennas, one for each frequency band. However, it is beneficial for the operator to use the same cables to and from the two antennas, or the dual band antenna, serving a specific geographic area, and thus the need for a combiner or a filter for separating the different frequency bands arises.

Conventionally, such high-power filters may, for instance, be designed using cavity resonator filters according to known techniques. Such filters have generally been satisfactory in function but are bulky, expensive and require manual tuning for optimal performance. Another example of a conventional high-power filter comprises a wire transmission line along a central axis of a cylindrical metal housing. The transmission line is connected to a series of circular metal plates that perpendicularly intersects the line. The plates are circumferentially spaced apart from the grounded housing by a dielectric material to create a capacitive coupling effective to shunt high frequencies. Such filters have also been generally satisfactory for suppressing harmonic spurs or high frequencies, but are massive in construction and expensive. It would be beneficial if a filter could be designed which is easy to manufacture, which does not require manual tuning, and which is smaller and less costly.

These requirements can be met by a microstrip, or a stripline, filter. However, microstrip filters are generally not suitable for high-power filter applications due to, for instance, high insertion loss, which reduces the power of the signal beyond acceptable values.

In US-5,153,542 'Multidielectric Microstrip Filter', assigned to Motorola Inc, a high-power microstrip filter is disclosed. Two different dielectric materials separate a transmission line and the ground plane, and radial pads, and the ground plane, respectively. The radial pads, cooperate, through a first of the two dielectric materials, with the ground plane for attenuating harmonic spurs. Along the transmission line several apertures are positioned and are filled with a second one of said two dielectric materials, preferably air, which reduces the capacitive coupling with the ground plane.

The use of several apertures interposed with support parts for supporting the transmission line results in a somewhat cumbersome solution. The support parts are necessary, according to the cited patent, for supporting the transmission line and for enabling conductive coupling between the transmission line and the radial pads. One problem which may occur with this arrangement is that the support parts also introduce an increased capacitive coupling, caused by the circuit board at those points where high currents occur and where, possibly, the best need for a reduced capacitive coupling is present. It would be beneficial if this capacitive coupling, at the support parts, could be reduced.

It is also very difficult to selectively vary the characteristic impedance along the transmission line, which in turn may impede the freedom of design. It would be beneficial if the freedom in designing the filter characteristics could be increased.

The design in US 5,153,542 is also a broad-band design meaning that the filter is used for attenuating signals in a very broad frequency band above the low-pass frequency band. This filter design requirement may cause restrictions on the building practice.

### SUMMARY OF INVENTION

The main object of the present invention is to achieve a high-power filter for filtering signals in a first frequency band. The filter should be small, capable of handling high-power applications, and easy to manufacture with low production costs.

Another object of the present invention, according to a preferred embodiment, is to provide a high-power filtering device which has an increased freedom in design of filter characteristics.

In more detail, the problems described above, how to achieve a small, low cost filter for high-power applications are solved by providing a filter comprising a first and a second signal port arranged to pass signals of said first frequency band and at least a first ground plane. The filter further comprises an elongated conductor extending substantially in parallel with said ground plane means providing a first signal path for said frequency band between said first and second ports, at least a first conductive segment having first radio frequency characteristics and being connected to said signal path at a first interconnection point, and said first characteristics and the position of said first interconnection point being selected such that radio frequencies outside said first frequency band are effectively attenuated in said first signal path. The filter is characterized by the features stated in claim 1.

According to a preferred embodiment of the invention, the radio frequency characteristics are selected such that signals in a second frequency band above said first frequency band are effectively attenuated.

The objects of the present invention, according to a preferred embodiment, are obtained by providing a filter where said signal path has narrower and broader parts to form different characteristic impedance along the signal path and where said characteristic impedance of said signal path cooperates with the frequency characteristics of said conductive segment to attenuate frequencies in at least a second frequency band above said first frequency band.

An advantage with the present invention is that a small, low-cost filter device is achieved.

A further advantage is that a relative robust conductive material can be used where the current has its peak values and a material of high dielectric strength can be used where the electric field reaches high values. Thereby, a further advantage is achieved, namely that the losses can be kept low and power handling capabilities can be kept high.

If the dielectric material is a printed circuit board then high mechanical tolerances can be maintained so as to facilitate the production of a tuning free filter.

Another advantage is that a transmission line which is capable of handling high-power signals is achieved.

Another main advantage is that the relation between the distance to the ground plane and the width of the conducting portions can be chosen according to need or desire.

### BRIEF DESCRIPTION OF THE DRAWINGS

The present invention will become more fully understood from the detailed description given hereinbelow with reference to the accompanying drawings, wherein:
Figure 1 shows a combiner/splitter means according to a preferred embodiment of the invention;
Figure 2 shows a cross sectional view of the combiner/splitter means in figure 1 taken at line I-I;
Figure 3 shows a diagrammatic view of the embodiment depicted in figure 1;
Figure 4, 5a and 5b shows diagrammatic views of different applications of the combiner/splitter according to preferred embodiments of the invention;
Figure 6, 7 and 8 shows cross sectional views of combiners/splitters according to preferred embodiments of the invention;
Figure 9 shows a perspective view of the preferred embodiment of the invention disclosed in figure 1.

### DETAILED DESCRIPTION OF PREFERRED EMBODIMENTS

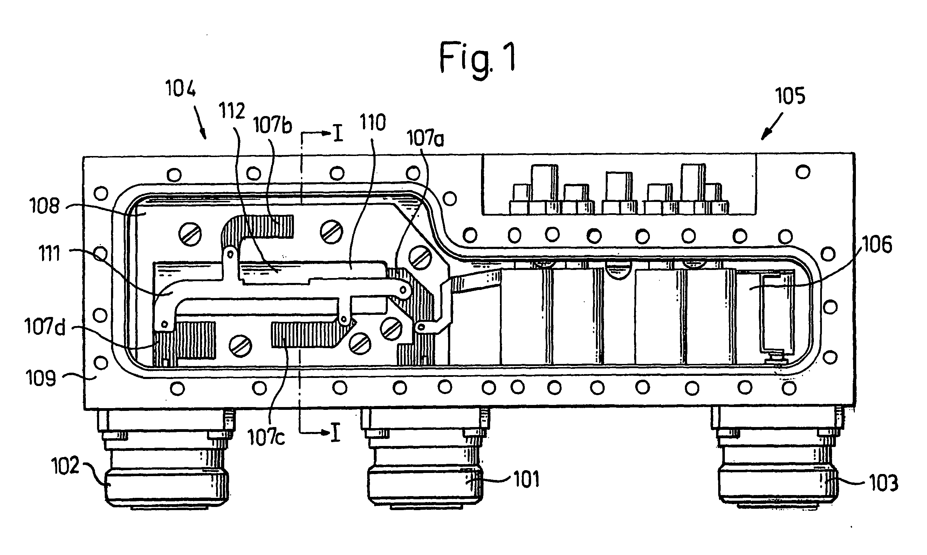

In figure 1 there is shown a filter device according to a preferred embodiment of the invention, with a lid removed for the sake of clarity. The filter device comprises a first input means 101, a first output means 102 and a second output means 103. The input signal comprises at least two different frequency bands, in this preferred embodiment the GSM band which is located at 900 Mhz and the PCN band which is located at 1800 Mhz. It is, however, possible to apply the invention to other specific frequency bands as well. The input signal is fed to a first low-pass filter arrangement 104 which will be further described below and a second band-pass filter arrangement 105. The second filter arrangement, for filtering the input signal according to a second filtering scheme, receives the input signal through the input means 101 and passes it through a number of coaxial resonators 106 resulting in a signal which is band-pass filtered to let through the PCN band of 1800 Mhz. Such a filter arrangement is known per se and is not further described here.

It shall be noted that even though input and output means have conveniently been used for describing the function of the device in a simple and easy to understand manner, the device described in this paper is a duplex device. Thus, the terms input and output means do not indicate any direction of signal propagation, but rather, the signals may propagate from an input means, as well as into an output means.

The first filter arrangement, for filtering the input signal according to a first scheme, receives the input signal at the input means 101. The signal is further transferred on a conductive pattern 107 on a printed circuit board 108 towards an opening or an aperture 110 on said printed circuit board 108. The printed circuit board is secured on a metallic or more generally a conductive body 109 with bolts or, alternatively, by means of screws, an adhesive or any other fastening means. The conductive body 109 is effectively a ground plane located at a first distance from said conductive pattern 107. As an alternative, the ground plane may be affixed on the printed circuit board at an opposite side to the conductive pattern 107. The conductive pattern 107 consists, in this preferred embodiment, of four disjoint parts 107a-d. In other embodiments more or fewer parts may be employed.

In conductive contact with all the disjoint parts 107a-d of the conductive pattern 107 and positioned over the opening or aperture 110 is a stiff conductive transmission line 111 in the form of a conductive plate. Aligned with the opening or aperture 110 is also a recess in the conductive body 109 forming the ground plane, so that the transmission line 111 is located a second distance to said ground plane which is larger than said first distance. The transmission line 111 comprises protruding parts which are soldered to the end portions of the conductive pattern 107 so that a conductive coupling is achieved. Other methods of achieving this coupling may include conductive adhesive agents, bolts, screws or any other fastening means. The transmission line has broader and narrower passages 112, and the parts 107b and 107c, together with the protruding parts, form stubs, in order to achieve the desired filtering, according to known techniques. The part 107d of the conductive pattern 107 connects the transmission line 111 to the output means 102.

The stiff conductive transmission line can be achieved by for instance etching, which gives a very high precision, or punching or in any other way known to the man skilled in the art.

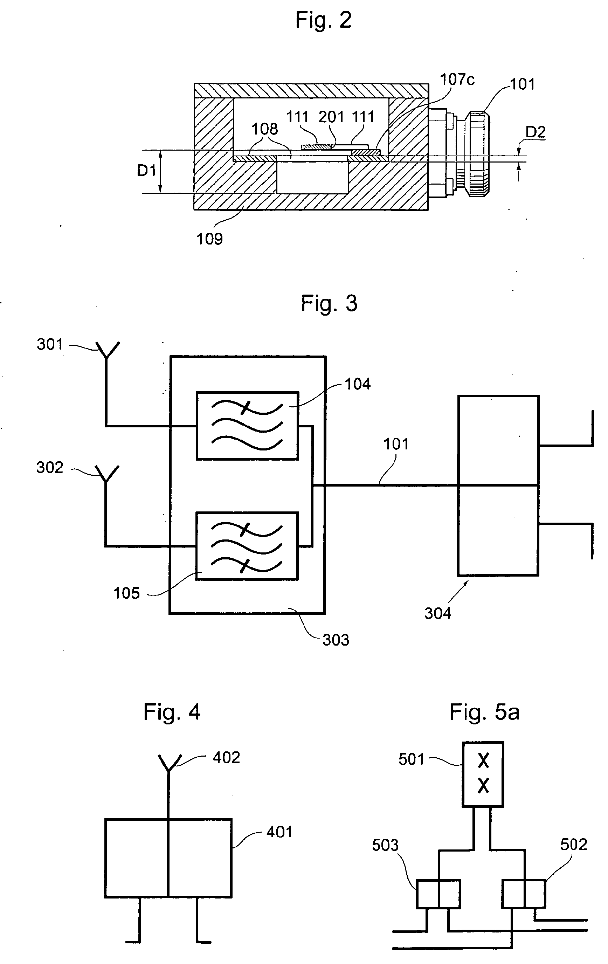

Figure 2 shows a cross section of figure 1 at line I-I. In this view, the distance D1 between the transmission line 111 and the conductive body 109, and the distance D2 between the conductive pattern 107 and the conductive body 109, which forms the ground plane, is clearly visible. An interconnection point 201 connects the transmission line 111 with the conductive pattern 107a. Such an interconnection point is present for all disjoint parts of the conductive pattern 107 with the transmission line. These are all located so that air separates the interconnection point 201 and the ground plane 109. This is one significant step in achieving a high power filter since high currents may occur in these points. It shall be noted that an interconnection point is not necessarily the same as a soldering point. The interconnection point simply indicates the position where transmission line interfaces the stubs, which, in this particular preferred embodiment, is formed by the protruding part of the stiff conductive transmission line together with the disjoint parts, and has nothing to do with how the electrical or mechanical connection between the two is achieved.

Figure 3 shows a diagrammatic view of the preferred embodiment according to the invention. The low-pass filter 104 is connected to a first antenna 301 adapted for transmitting and receiving signals in a first frequency, in this embodiment around 800 Mhz for the GSM band. The band-pass filter 105 is similarly connected to a second antenna 302 adapted for transmitting and receiving signals in a second frequency band, in this embodiment around 1800 Mhz for the PCN band. Both filters 104 and 105 are connected to a common input means 101. A transmission line connects the first combiner/splitter 303 to a second similar combiner/splitter 304 for further transmission of the different frequency bands to respective application. Thus a single transmission line can be used for transmitting signals in the two frequency bands.

Figure 4 shows a different arrangement where a dual band antenna 402 is used. In this case, only one combiner/splitter 401 is used.

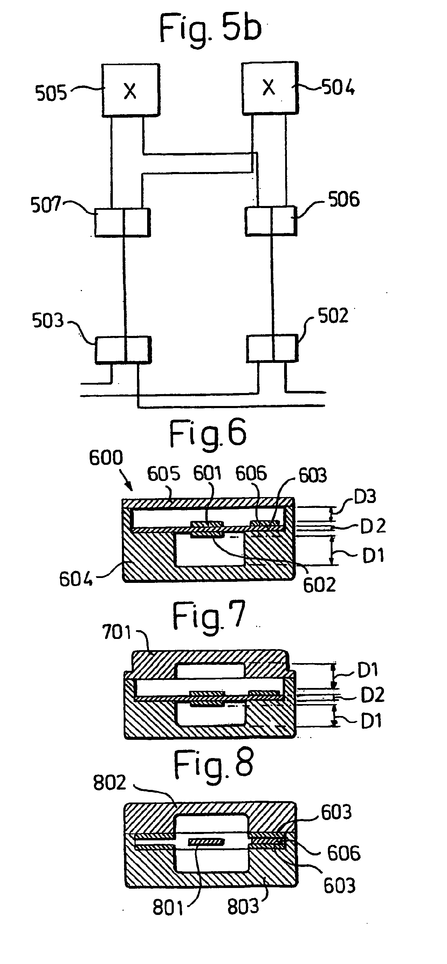

Figure 5a illustrates an arrangement where a dual band, dual polarization antenna 501 is used. First and second combiners/splitters 502, 503 are used, one for each polarization. Figure 5b shows an arrangement where two dual polarization antennas are used 504, 505, one for each frequency band. Thus, another two combiners/splitters 506, 507 are required.

Though one filter has been described as a low-pass filter and the other as a band-pass filter in this embodiment, it is obvious for the person skilled in the art that many types of filters can be designed using the inventive concepts in the present disclosure, for instance band-stop filters or two band-pass filters or any other combination suitable for achieving the filter schemes desired.

Figure 6 shows a cross sectional view of another preferred embodiment according the invention. In this embodiment a transmission line has a first and a second conductive strip 601 and 602 on opposite sides of a printed circuit board. The second conductive strip cooperates with a conductive body 604 having a recess, and forming a ground plane at a distance D1 from said second strip 602. The filter 600 also comprises a lid 605, in conductive contact with said conductive body and thus being a part of said ground plane and cooperating with the first conductive strip 601 at a distance D3. The lid 605 and the conductive body 604 form a housing for the filter. The filter further comprises conductive stubs 606 at a distance D2 from said ground plane.

By using the housing as a ground plane for the filter 600, inter-modulation problems can be avoided. It has been noted that using a conventional circuit board having a copper plated backside may cause inter-modulation problems when arranged in a housing. The simple, yet ingenious, solution is to use a conductive, grounded housing as ground plane.

Figure 7 shows a cross sectional view of another preferred embodiment according to the invention. In this embodiment the distance D3 has been selected to be equal to the distance D1 in figure 6 by designing a lid 701 with a recess. In all other aspects the embodiment in figure 7 is the same as the embodiment in figure 6.

Figure 8 shows a preferred embodiment where a stripline has been used, the most significant difference being that a symmetric cross-section has been achieved. Thus, the conductive stubs 606 have the same material 603 with a relative high dielectric constant on both sides facing the ground plane means, whereas the transmission line 801 is separated from both of the ground plane means 802, 803 by air.

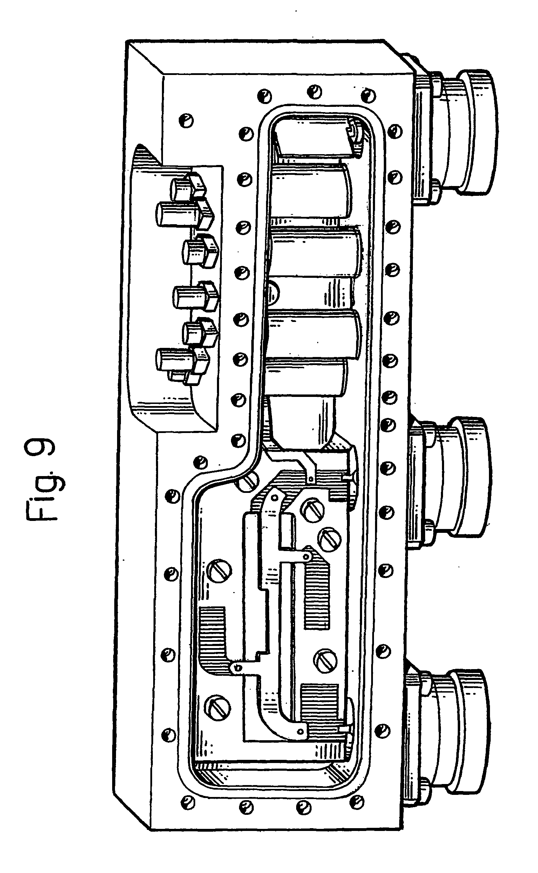

Figure 9 discloses the same preferred embodiment as previously disclosed in figure 1, also here with the lid removed for the sake of clarity.

## Claims

1. A filter including a first filter portion (104) for passing radio frequency signals of a first frequency band, comprising:
- a first signal port (101) arranged to pass signals of said first frequency band,
- a second signal port (102) arranged to pass signals of said first frequency band,
- a signal ground plane (109),
- an elongated conductor (111) extending at least partly on a dielectric board (108), having a first dielectric, substantially in parallel with said ground plane and providing a first transmission line for said first frequency band between said first and second ports (101, 102),
- said elongated conductor (111) adjoining to at least one conductive stub (111, 107b, 107c), having a segment located on said dielectric board and having radio frequency characteristics and being connected to said elongated conductor at an interconnection point (201), such that radio frequencies outside said first frequency band are effectively attenuated in said first transmission line,
- there being a first distance (D2) between said segment (107b, 107c) of said at least one conductive stub and said signal ground plane,
- said segment being separated from said ground plane by said first dielectric,
**characterized in that**
- said first filter portion (104) is arranged in a conductive, grounded housing (109; 604, 605) forming at least a part of said signal ground plane,
- a substantial part of said elongated conductor (111) and at least one interconnection point (201) are separated from said ground plane by a second dielectric, having approximately the same dielectric constant as vacuum, and
- said ground plane is configured such that there is a second distance (D1) between said signal ground plane and said at least one interconnection point (201), said second distance (D1) being larger than said first distance (D2) such that the capacitive coupling is reduced between the transmission line, at said interconnection point(s), and said ground plane of the housing so as to permit high currents with low losses at said interconnection point(s).

2. Filter according to claim 1, wherein
- said elongated conductor (111) comprises distributed components in the form of narrower and broader parts (112),
- said distributed components cooperate with said first radio frequency characteristics and said interconnection point(s) to effectively attenuate frequencies outside said first frequency band.

3. Filter according to claim 1 or 2, wherein
- a segment (107b, 107c) of said conductive stub extends at least partly in parallel with said elongated conductor (111).

4. Filter according to any one of claims 1-3, wherein said elongated conductor (111) is formed by a stiff conductive plate positioned over an opening or aperture (110) of said dielectric board (108).

5. Filter according to any one of claims 1-3, wherein
- said elongated conductor comprises first and second conductive strips (601, 602) on opposite sides of said dielectric board (603),
- said second conductor strip (602) extends substantially in parallel, and cooperating, with said signal ground plane and with said first conductor strip (601) to form said transmission line, and
- both of said first and second conductor strips (601, 602) being located at distances (D1,D3), from said signal ground plane, being larger than said first distance (D2).

6. Filter according to any one of claims 1-5, wherein said housing is also provided with a second filter portion (105) and a third signal port (103) for passing radio frequency signals of a second frequency band, which is higher than said first frequency band, whereby said filter serves as a high-power, dual band filter.

## Patentansprüche

1. Filter mit einem ersten Filterteil (104), welcher Hochfrequenzsignale eines ersten Frequenzbandes durchlässt und aufweist:
- einen ersten Signalanschluss (101), welcher so eingerichtet ist, dass er Signale des ersten Frequenzbandes durchlässt,
- einen zweiten Signalanschluss (102), der so eingerichtet ist, dass er Signale des ersten Frequenzbandes durchlässt,
- eine Signalmasseebene (Signal-ground plane) (109),
- einen länglichen Leiter (111), der sich wenigstens teilweise auf einer dielektrischen Platte (108) erstreckt, die ein erstes Dielektrikum hat, im Wesentlichen parallel zu der Masseebene (ground plane) verläuft und eine erste Übertragungsleitung für das erste Frequenzband zwischen dem ersten Anschluss und zweiten Anschluss (101, 102) liefert, wobei
- der längliche Leiter (111) an wenigstens eine leitende Stichleitung (111, 107b, 107c) anschließt, die ein auf der dielektrischen Platte angeordnetes Segment hat, Hochfrequenzcharakteristika aufweist und mit dem länglichen Leiter an einem Verbindungspunkt (201) verbunden ist, so dass Hochfrequenzen außerhalb des ersten Frequenzbandes in der ersten Übertragungsleitung wirksam gedämpft werden, wobei
- ein erster Abstand (D2) zwischen den Segmenten (107b, 107c) der wenigstens einen leitenden Stichleitung und der Signalmasseebene vorhanden ist,
- wobei das Segment von der Masseebene durch das erste Dielektrikum getrennt ist,
**dadurch gekennzeichnet, dass**
- der erste Filterteil (104) in einem leitenden geerdeten Gehäuse (109, 604, 605) angeordnet ist, das wenigstens einen Teil der Signalmasseebene bildet,
- ein wesentlicher Teil des länglichen Leiters (111) und wenigstens ein Verbindungspunkt (201) von der Masseebene getrennt sind durch ein zweites Dielektrikum mit annähernd der gleichen Dielektrizitätskonstante wie Vakuum, und
- die Masseebene (ground plane) so konfiguriert ist, dass ein zweiter Abstand (D1) zwischen der Signalmasseebene und dem wenigstens einen Verbindungspunkt (201) vorhanden ist, wobei der zweite Abstand (D1) größer als der erste Abstand (D2) ist, so dass die kapazitive Kopplung zwischen der Übertragungsleitung und der Masseebene des Gehäuses an dem Verbindungspunkt (den Verbindungspunkten) verringert ist, so dass an dem Verbindungspunkt (den Verbindungspunkten) starke Ströme mit geringen Verlusten ermöglicht werden.

2. Filter nach Anspruch 1, worin
- der längliche Leiter (111) verteilte Komponenten in Form von schmaleren und breiteren Teilen (112) aufweist,
- die verteilten Komponenten mit den ersten Hochfrequenzcharakteristika und dem Verbindungspunkt (den Verbindungspunkten) zusammenwirken, um Frequenzen außerhalb des ersten Frequenzbandes wirksam zu dämpfen.

3. Filter nach Anspruch 1 oder 2, worin
- ein Segment (107b, 107c) der leitenden Stichleitung sich wenigstens teilweise parallel mit dem länglichen Leiter (111) erstreckt.

4. Filter nach einem der Ansprüche 1 bis 3, worin der längliche Leiter (111) durch eine steife leitende Platte gebildet ist, die über einer Öffnung oder Apertur (110) der dielektrischen Platte (108) angeordnet ist.

5. Filter nach einem der Ansprüche 1 bis 3, worin
- der längliche Leiter erste und zweite leitende Streifen (601, 602) auf entgegengesetzten Seiten der dielektrischen Platte (603) aufweist,
- der zweite Leiterstreifen (602) sich im Wesentlichen parallel mit der Signalmasseebene und mit dem ersten Leiterstreifen (601) erstreckt und mit diesem zusammenwirkt, um die Übertragungsleitung zu bilden, und
- beide, der erste und der zweite Leiterstreifen (601, 602) in einem Abstand (D1, D3) von der Signalmasseebene angeordnet sind, der größer als der erste Abstand (D2) ist.

6. Filter nach einem der Ansprüche 1 bis 5, worin das Gehäuse auch mit einem zweiten Filterteil (105) und einem dritten Signalanschluss (103) ausgerüstet ist, um Hochfrequenzsignale eines zweiten Frequenzbandes, das höher als das erste Frequenzband ist, durchzulassen, wodurch das Filter als ein Hochleistungsdualbandfilter dient.

## Revendications

1. Filtre comprenant une première partie de filtre (104) destinée à faire passer des signaux de fréquences radio ayant une première bande de fréquences, comprenant :
◆ un premier port de signaux (101) agencé afin de faire passer les signaux ayant ladite première bande de fréquences,
◆ un second port de signaux (102) agencé afin de faire passer les signaux ayant ladite première bande de fréquences,
◆ un plan de masse de signaux (109),
◆ un conducteur allongé (111) s'étendant au moins partiellement sur un panneau diélectrique (108) ayant un premier diélectrique, sensiblement en parallèle avec ledit plan de masse et offrant une première ligne de transmission pour ladite première bande de fréquences entre lesdits premier et second ports (101, 102),
◆ ledit conducteur allongé (111) étant joint à au moins une embase conductrice (111, 107b, 107c), ayant un segment situé sur ledit panneau diélectrique et ayant des caractéristiques de fréquences radio et étant reliée audit conducteur allongé au niveau d'un point d'interconnexion (201), afin que les fréquences radio situées en-dehors de ladite première bande de fréquences soient atténuées efficacement sur ladite première ligne de transmission,
◆ une première distance (D2) entre ledit segment (107b, 107c) de ladite embase conductrice au moins et ledit plan de masse de signaux,
◆ ledit segment étant séparé dudit plan de masse par ledit premier diélectrique,
**caractérisé en ce que**
◆ ladite première partie de filtre (104) est agencée dans un logement conducteur mis à la masse (109 ; 604, 605) formant au moins une partie dudit plan de masse de signaux,
◆ une partie substantielle dudit conducteur allongé (111) et au moins un point d'interconnexion (201) sont séparés dudit plan de masse par un second diélectrique, ayant approximativement la même constante diélectrique que le vide, et
◆ ledit plan de masse est configuré afin qu'il existe une seconde distance (D1) entre ledit plan de masse de signaux et ledit point d'interconnexion au moins (201), ladite seconde distance (D1) étant supérieure à ladite première distance (D2) afin que le couplage capacitif soit réduit entre la ligne de transmission, au niveau dudit point d'interconnexion (s), et ledit plan de masse du logement de façon à permettre des courants élevés avec de faibles pertes au niveau dudit point d'interconnexion (s).

2. Filtre selon la revendication 1, dans lequel
◆ ledit conducteur allongé (111) comprend des composants distribués sous la forme de parties plus étroites et plus larges (112),
◆ lesdits composants distribués coopèrent avec lesdites premières caractéristiques de fréquences radio et ledit point d'interconnexion (s) de façon à atténuer efficacement les fréquences situées en-dehors de ladite première bande de fréquences.

3. Filtre selon la revendication 1 ou 2, dans lequel
◆ un segment (107b, 107c) de ladite embase conductrice s'étend au moins partiellement en parallèle avec ledit conducteur allongé (111).

4. Filtre selon l'une quelconque des revendications 1 à 3, dans lequel ledit conducteur allongé (111) est formé par une plaque conductrice rigide positionnée par-dessus une ouverture (110) dudit panneau diélectrique (108).

5. Filtre selon l'une quelconque des revendications 1 à 3, dans lequel
◆ ledit conducteur allongé comprend une première et une seconde bandes conductrices (601, 602) sur les côtés opposés dudit panneau diélectrique (603),
◆ ladite seconde bande conductrice (602) s'étend sensiblement en parallèle à, et coopère avec, ledit plan de masse de signaux et avec ladite première bande conductrice (601) afin de former ladite ligne de transmission, et
◆ lesdites première et seconde bandes conductrices (601, 602) étant situées à des distances (D1, D3), par rapport audit plan de masse de signaux, étant supérieures à ladite première distance (D2).

6. Filtre selon l'une quelconque des revendications 1 à 5, dans lequel ledit logement est également muni d'une seconde partie de filtre (105) et d'un troisième port de signaux (103) per-mettant de faire passer des signaux de fréquences radio ayant une seconde bande de fréquences, qui est supérieure à ladite première bande de fréquences, moyennant quoi ledit filtre sert de filtre à bande double et à puissance élevée.
